(19) Europäisches Patentamt
European Patent Office
Office européen des brevets

(11) **EP 4 575 537 A1**

(12) **EUROPEAN PATENT APPLICATION**

(43) Date of publication:
**25.06.2025 Bulletin 2025/26**

(21) Application number: **23219645.1**

(22) Date of filing: **22.12.2023**

(51) International Patent Classification (IPC):
**G01R 31/367** (2019.01)   **G01R 31/382** (2019.01)
**G01R 31/396** (2019.01)

(52) Cooperative Patent Classification (CPC):
**G01R 31/382; G01R 31/367; G01R 31/396;**
G01R 31/374; G01R 31/387; G01R 31/392

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **VOLVO TRUCK CORPORATION**
**405 08 Göteborg (SE)**

(72) Inventors:
• **ADELSSON, Per**
**418 77 GÖTEBORG (SE)**
• **NETTO, Diego Santos Pereira**
**436 37 ASKIM (SE)**

(74) Representative: **Kransell & Wennborg KB**
**P.O. Box 2096**
**403 12 Göteborg (SE)**

Remarks:
Amended claims in accordance with Rule 137(2)
EPC.

(54) **IMPROVED BATTERY CELL TERMINAL VOLTAGE ESTIMATION**

(57)     A computer system (400) for estimating a terminal voltage ($V_{Ci}$) of a battery cell of a battery (100) is provided. The terminal is electrically connected to another object (such as another battery cell) via e.g. a cell-to-cell busbar. Processing circuitry (410) is configured to obtain a voltage drop ($V_{(i-1)} - V_i$) across at least the battery cell and at least part of the busbar; obtain a voltage correction value ($V_{Z(i-1),2}; V_{Zi,1}$) from a model (430) of voltage drop across the busbar, and estimate the terminal voltage based on the voltage drop corrected by the voltage correction value ($V_{ci} \approx V_{(i-1)} - V_i - V_{Z(i-1),2} - V_{Zi,1}$). A corresponding battery arrangement, vehicle, method and computer program product are also provided.

Fig. 1

# Description

## TECHNICAL FIELD

The disclosure relates generally to the field of batteries as found in e.g. electric vehicles. In particular aspects, the disclosure relates to improvements of battery cell terminal voltage estimation in such batteries. The disclosure can e.g. be applied to heavy-duty vehicles, such as trucks, buses, and construction equipment, among other vehicle types, and battery cells and batteries found therein. Although the disclosure may be described with respect to e.g. a particular vehicle, the disclosure is not restricted to any particular vehicle.

## BACKGROUND

A battery management system may be responsible for managing a rechargeable battery, including to protect the battery from operating outside its safe operating area, including protection from over- and/or under-charging, as well as to perform internal battery cell-balancing, and/or to monitor one or more states of the battery and its battery cells. Such states may include state of charge (SoC), state of health (SoH), state of power (SoP), state of energy (SoE), state of safety (SoS), and various other figures of merit that may all be summarized as being examples of a so-called state of everything/state of X (SoX).

Perfect estimation of such figures of merit often requires exact knowledge about the chemical and/or thermodynamic processes taking place within the battery cells themselves, i.e. based on information not available to the battery management system. Instead, contemporary battery management systems attempt to estimate/predict such figures of merits based on more easily accessible information, such as e.g. based on measurements of voltage, current, temperature, and similar, that may be performed by use of reasonably simple and accessible sensors together with more or less complex models of the internal workings of the battery and battery cells. Newer systems sometimes also rely on machine learning in order to find mappings between parameters such as voltage, current, temperature, and similar, and one or more SoX values.

For reasons such as overall complexity, cost and manufacturability, it is desirable to keep the number of sensors used to perform such measurements to a minimum, especially as there may be a large number of individual battery cells in a battery, and as providing additional sensors also produces additional measurement data that also needs to be processed by e.g. a control unit having limited processing resources. In addition, it is desirable that the measurements actually performed are as accurate as possible, as inaccurate measurement values may negatively influence the battery management performed based on such measurements. The present disclosure aims at further developing contemporary battery management technology and to at least partially resolve one or more issues therewith.

## SUMMARY

According to a first aspect of the present disclosure, there is provided a computer system for estimating a terminal voltage of a battery cell of a battery, wherein a terminal of the battery cell is electrically connected to another object (such as e.g. another battery cell, a battery terminal, or similar) of the battery via an electrical connection element (such as e.g. a cell-to-cell busbar). The computer system includes processing circuitry configured to: obtain a first voltage drop value indicative of a voltage drop across at least i) the battery cell and ii) at least a part of the electrical connection element; obtain a voltage correction value from model of voltage drop across the electrical connection element, and estimate a terminal voltage of the battery cell based on the first voltage drop value corrected by the voltage correction value. The first aspect of the disclosure may seek to provide a more accurate estimation of the battery cell terminal voltage. A technical benefit may include that taking into account that part of a measured battery terminal voltage often includes part of the electrical connection elements (such as e.g. cell-to-cell busbars) used to connect the battery cell e.g. in series with one or more other battery cells may allow to compensate for such additional voltage drop when estimating the true battery cell terminal voltage, and in particular that this may be obtained based on a model of e.g. the busbar stored in (or at least accessible from) the computer system. This in particular when so called single spot measurements are performed, wherein voltages are measured only for a single point on each cell-to-cell busbar in order to e.g. reduce the total number of measurement points, sensors and overall measurement data size.

Optionally in some examples, including in at least one preferred example, of computer system, the model of voltage drop may depend on a current through the electrical connection element. The processing circuitry may be further configured to obtain a current value indicative of a current through the electrical connection element, and obtain the voltage correction value from the model based on the current value. A technical benefit may include that the battery cell terminal voltage estimation may be further improved by taking into account that the voltage drop may depend on the current through the electrical connection element.

Optionally in some examples, including in at least one preferred example, of the computer system, the model of voltage drop may depend on a temperature of the electrical connection element. The processing circuitry may be configured to obtain a temperature value indicative of a temperature of the electrical connection element, and obtain the voltage correction value from the model based (also) on the temperature value. A technical benefit may include that the battery cell terminal voltage estimation may be further improved by taking into account (also) that the voltage drop may depend on the temperature of the electrical connection element.

Optionally, in some examples, including in at least one preferred example, of the computer system, the model of voltage drop may be specific for a voltage drop between a point of the electrical connection element used for obtaining the first voltage drop value and a point of the electrical connection element used for attaching the electrical connection element to the terminal of the battery cell. A technical benefit may include that the (exact) location of where the single spot measurement is performed on the electrical connection element may be taken into account, and that e.g. a current distribution within the electrical connection element may be different at different locations on/of the electrical connection element, thus further improving the estimation of the battery cell terminal voltage.

Optionally, in some examples, including in at least one preferred example, of the computer system, the processing circuitry may be further configured to determine a state of X (or everything, i.e. SoX) value for the battery cell based on the estimated terminal voltage of the battery cell. A technical benefit may include that such a SoX value estimation/calculation may be more accurate due to the estimated terminal voltage of the battery cell being more accurate.

Optionally, in some examples, including in at least one preferred example, of the computer system, the processing circuitry may be further configured to control a charging and/or discharging of the battery cell or battery based on the determined SoX value for the battery cell (and e.g. based on one or more such SoX values determined for one or more other battery cells of the battery). A technical benefit may include that the battery cell and battery may therefore be managed in an improved way due to the more exact knowledge about the real battery cell terminal voltage, which may lead to e.g. an improved battery (cell) life, safety, cost efficiency, and similar.

According to a second aspect of the present disclosure, there is provided a battery arrangement. The battery arrangement includes a battery that includes a plurality of battery cells electrically connected in series via a plurality of electrical connection elements (such as e.g. cell-to-cell busbars). The battery arrangement further includes the computer system of the first aspect (or any example thereof), for estimating a terminal voltage of at least one of the battery cells.

Optionally, in some examples, including in at least one preferred example, of the battery arrangement, the electrical connection elements may be cell-to-cell busbars.

According to a third aspect of the present disclosure, there is provided a vehicle. The vehicle includes the battery arrangement of the second aspect or any example thereof, i.e. at least a battery with a plurality of battery cells, and the computer system of the first aspect for at least estimating a battery cell terminal voltage of at least one battery cell of the battery. The vehicle may be a heavy electric vehicle, heavy hybrid electric vehicle, or similar, examples of which include trucks, buses, dumpers, construction equipment, and similar, and also e.g. marine vessels such as boats, ships, ferries, and similar, and in particular vehicles wherein the battery provides electrical power to one or more electrical machines responsible for propelling the vehicle.

According to a fourth aspect of the present disclosure, there is provided a method of/for estimating a terminal voltage of a battery cell of a battery, wherein a terminal of the battery cell is electrically connected to another object (such as e.g. another battery cell) of the battery via an electrical connection element (such as e.g. a cell-to-cell busbar). The method is a computer-implemented method and is performed by processing circuitry of a computer system. The method includes (by the processing circuitry) obtaining a first voltage drop value indicative of a voltage drop across at least i) the battery cell and ii) at least a part of the electrical connection element; obtaining a voltage correction value from a model of voltage drop across the electrical connection element, and estimating a terminal voltage of the battery cell based on the first voltage drop value corrected by the voltage correction value.

Optionally, in some examples, including in at least one preferred example, of the method, the model of voltage drop may depend on a current through the electrical connection element, and the method may further include: obtaining a current value indicative of a current through the electrical connection element, and obtaining the voltage correction value from the model based on the current value.

Optionally, in some examples, including in at least one preferred example, of the method, the model of voltage drop may depend on a temperature of the electrical connection element, and the method may further include: obtaining a temperature value indicative of a temperature of the electrical connection element, and obtaining the voltage correction value from the model based (also) on the temperature value.

Optionally, in some examples, including in at least one preferred example, of the method, the model of voltage drop may be specific for a voltage drop between a point of the electrical connection element used for obtaining the first voltage drop value and a point of the electrical connection element used for attaching the electrical connection element to the terminal of the battery cell.

Optionally, in some examples, including in at least one preferred example, of the method, the method may further include providing the model of voltage drop based on numerical simulations of voltage drop for the electrical connection element. In some examples, such numerical simulations may include (or be based on) finite element methods/analysis (FEM/FEA) or any suitable derivates thereof. A technical benefit may include that e.g. things like the geometry of the busbar, the location of the point of the electrical connection element where it attaches/connects to the terminal of the battery cell, the location of the point of the electrical connection element where the voltage drop measurement is performed, a material of the electrical connection element, a temperature of the electrical connection element, and/or a current or current distribution of the electrical connection element, etc., may each or in any combination be taken into account as part of the model, and thereby provide more accurate estimations of how much of the overall first voltage drop value that originates from part or all of the electrical connection element and not the battery cell terminal voltage.

According to a fifth aspect of the present disclosure, there is provided a computer program product. The computer program product includes program code for performing, when executed by a processing circuitry of a computer system, the method of the fourth aspect (or any example thereof).

According to a sixth aspect of the present disclosure, there is provided a computer-readable storage medium including instructions, which when executed by the processing circuitry, cause the processing circuitry to perform the method of the fourth aspect (or any example thereof). The storage medium may be non-transitory.

Just as for the first aspect, each of the second, third, fourth, fifth and sixth aspects may also seek to provide a more accurate estimation of the battery cell terminal voltage.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

BRIEF DESCRIPTION OF THE DRAWINGS

Examples are described in more detail below with reference to the appended drawings.

FIG. 1 schematically illustrates an exemplary battery including a plurality of battery cells according to an example of the present disclosure, wherein single spot voltage measurements are performed as part of estimating battery cell terminal voltages.

FIG. 2 schematically illustrates an electric circuit diagram equivalent of at least part of the battery of FIG. 1, exemplifying the effects of the electrical connector elements used to connect the battery cells together on the measured voltage drops according to an example of the present disclosure.

FIGS. 3A and 3B schematically illustrate exemplary electrical connection element (cell-to-cell busbars) models according to examples of the present disclosure.

FIG. 4 schematically illustrates a computer system for estimating a battery cell terminal voltage according to various examples of the present disclosure.

FIG. 5 schematically illustrates a flowchart of various exemplary methods of estimating a battery cell terminal voltage according to examples of the present disclosure.

FIG. 6 schematically illustrates an exemplary vehicle according to an example of the present disclosure.

FIG. 7 schematically illustrates a diagram of an exemplary computer system for implementing examples disclosed herein, according to an example of the present disclosure.

DETAILED DESCRIPTION

The detailed description set forth below provides information and examples of the disclosed technology with sufficient detail to enable those skilled in the art to practice the disclosure.

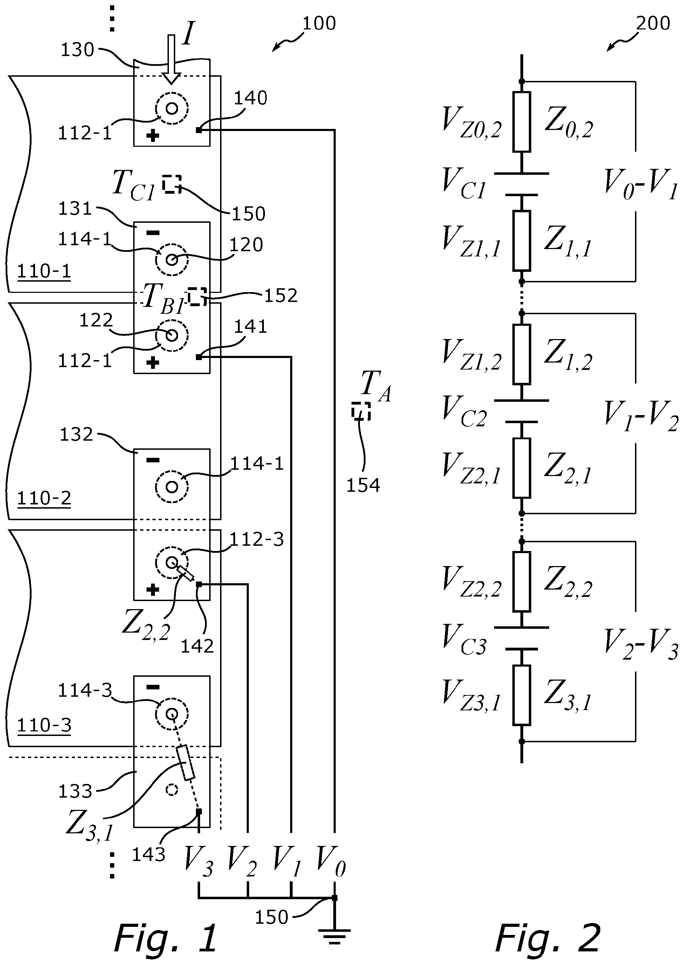

FIG. 1 schematically illustrates an exemplary battery 100 that includes a plurality of battery cells 110-1, 110-2, 110-3, etc. In this example, the battery cells 110-1 to 110-3 are connected in series using a plurality of electrical connector elements in form of cell-to-cell busbars 130, 131, 132 and 134. Each busbar 130-134 electrically connects (i.e. provides an electrically conductive path from) a negative terminal of a battery cell 110-i to a positive terminal of a next battery cell 100-(i-1). As an example, the busbar 130 connects the positive terminal 112-1 of the battery cell 110-1 to some other object of the battery 100 (such as another battery cell, a battery terminal, or similar); the busbar 131 connects a negative terminal 114-1 of the battery cell 110-1 to a positive terminal 112-2 of the battery cell 110-2; the busbar 132 connects a negative terminal 114-2 of the battery cell 110-2 to a positive terminal 112-3 of the battery cell 110-3, and the busbar 133 connects a negative terminal 114-3 of the battery cell 110-3 to some other object (such as another battery cell, a battery terminal, or similar) of the battery 100.

Each busbar 130-133 is provided with holes 120, 122 that are positioned on the corresponding battery cell terminal, and the busbars 130-133 are connected/attached to the corresponding battery cell terminal using e.g. welding (such as laser welding or similar) at/through the holes 120, 122. Phrased differently, the location of the holes 120, 122 are locations where the corresponding busbar 130-133 is connected/attached to the corresponding battery cell terminal, such that the location of the holes 120, 122 (which are e.g. filled with material, such as electrically conductive material, after being welded) is where current enters into/out from the busbar 130-133 from/to the corresponding battery cell terminals.

In order to estimate battery cell terminal voltages, i.e. the voltages across each pair of terminals 112-i and 114-i for each battery cell 110-i, there is provided a plurality of measurement points 140, 141, 142 and 143 on the respective busbar 130-133. From each measurement point 140-143, there is provided (i.e. attached, using e.g. soldering, welding or similar) a wire that is routed to circuitry (not shown) configured to measure voltages, e.g. a corresponding voltage $V_0$, $V_1$, $V_2$ and $V_3$ between the respective measurement point 130-133 and e.g. a common point 150, such as a grounding/earthing point or similar. It may not be necessary that such a common point 150 is grounded, if only differences between the voltages $V_0$ to $V_3$ are considered. By providing only a single spot/point of measurement on each busbar 130-133, the setup illustrated in FIG. 1 may be referred to as a single spot measurement setup, and may provide a reduced or even minimum number of required measurement points for estimation of all battery cell terminal voltages.

Optionally, one or more temperature sensors may also be provided as part of the battery 100 or an arrangement including the battery 100. For example, there may be provided one or more temperature sensors 150 responsible for measuring a temperature $T_{Ci}$ on each $i$:th battery cell 110-i, or e.g. for at least one or more of the battery cells 110-1 to 110-3. In other examples, there may instead or in addition be provided one or more temperature sensors 152 responsible for measuring a temperature $T_{Bi}$ on each $i$:th busbar 13i, or e.g. for at least one or more of the busbars 130-133. In other examples, there may instead or in addition be provided one or more temperature sensors 154 responsible for measuring an ambient temperature $T_A$ for/of the battery cells 110-1 to 110-3 and/or battery 100 as a whole, or similar. In particular, it is envisaged that there may optionally be one or more temperature sensors (such as 150, 152, 154) provided and configured to in some suitable way estimate a temperature of each busbar 130-133, either directly (via e.g. sensors 152) or indirectly (via e.g. sensors 150 and/or 154).

Optionally, one or more sensors suitable for measuring a current $I_i$ through each $i$:th busbar 130-133 may also be provided. Instead of e.g. providing individual current sensors for each busbar, a single current sensor (not shown) may be used to estimate/measure a current through all of the battery cells 110-1 to 110-3, e.g. a common current $I$ through the battery 100, or at least through a branch of the battery 100 including the series-connected battery cells 110-1 to 110-3, and similar.

A setup such as illustrated in FIG. 1 and described so far is known and used in contemporary solutions. A problem with such a setup is that if using the measured voltages $V_0$ to $V_3$ to directly estimate the battery cell terminal voltages, e.g. as a voltage $V_{C1} = V_0 - V_1$ across the terminals 112-1 and 114-1 of the battery cell 110-1, a voltage $V_{C2} = V_1 - V_2$ across the terminals 112-2 and 114-2 of the battery cell 110-2, a voltage $V_{C3} = V_2 - V_3$ across the terminals 112-3 and 114-3 of the battery cell 110-3, and so on, the effect of the busbars 130-133 themselves on such voltages are not accounted for, which will lead to inaccurate estimations $V_{C1}$ to $V_{C3}$ of the battery cell terminal voltages and thereby a reduced quality of battery management and e.g. SoX value-estimation. This because the busbars 130-133 are not perfect conductors, but instead provide a finite, non-zero resistance/impedance that will form voltage dividers together with the battery cells 110-1 to 110-3. Part of each of the estimated voltages $V_{C1}$ to $V_{C3}$ as obtained directly from the measurements of $V_0$ to $V_3$ will thus correspond to a voltage drop over at least part of the corresponding busbar 130 to 133. For example, if considering the busbar 132, there will be a finite (i.e. non-zero) impedance $Z_{2,2}$ between the measurement point 142 and the battery terminal 112-3. Likewise, if considering the busbar 133, there will be a finite (i.e. non-zero) impedance $Z_{3,1}$ between the measurement point 143 and the battery terminal 114-3, as schematically illustrated in FIG. 1.

FIG. 2 schematically illustrates a circuit diagram 200 equivalent to the setup of FIG. 1, at least for what concerns the estimation of the battery cell terminal voltages $V_{C1}$ to $V_{C3}$. As illustrated in FIG. 2, the difference $V_0 - V_1$ does not correspond exactly to $V_{C1}$, but also includes a voltage drop $V_{Z0,2}$ across an impedance $Z_{0,2}$ formed between the measurement point 140 and the battery cell terminal 112-1, as well as a voltage drop $V_{Z1,1}$ across an impedance $Z_{1,1}$ formed between the measurement point 141 and the battery cell terminal 114-1. Similarly, each difference $V_{(i-1)} - V_i$ includes not only the corresponding battery terminal voltage $V_{Ci}$, but also a voltage drop $V_{Z(i-1),2}$ across an impedance $Z_{(i-1),2}$ formed between the measurement point 14(i-1) and the battery cell terminal 112-i, and a voltage drop $V_{Zi,1}$ across an impedance $Z_{i,1}$ formed between the measurement point 14i and the battery cell terminal 114-i.

A known solution to the above problem is to provide more measurement points, and to e.g. move the measurement points closer to the battery cell terminal connection points. For example, by having two measurement points instead of one on each busbar, the effect of the finite impedance of the busbar will be less severe, and perhaps completely eliminated if it is possible to place the two measurement points on each busbar in the direct vicinity of the corresponding battery cell terminals. However, such a solution would then increase the amount of measurement wires that need to be provided, increase the amount of measurement data that has to be read out and processed, and likely also increase the required processing power needed for processing such data as well as the number of interfaces (such as I/O ports, analog-to-digital converters (ADCs) and similar) required to obtain readouts of voltages from all measurement points and wires. Other solutions may include the use of multiplexers in order to e.g. read out multiple measurement point voltages using e.g. a same ADC, but may still likely lead to a more complex solution with added hardware requirements. There are thus negative consequences associated with such a solution.

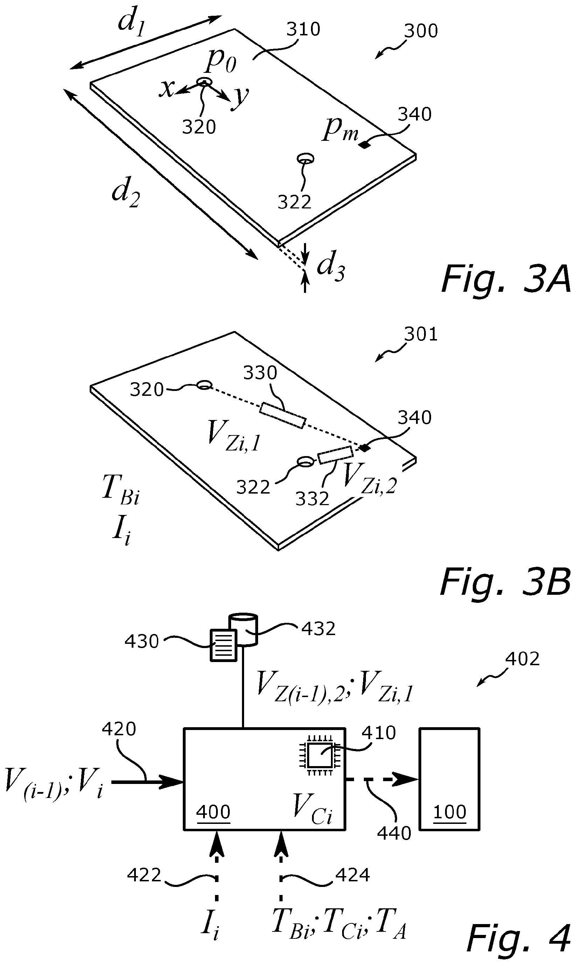

How the present disclosure improves upon such issues with contemporary technology will now be described in more detail with reference also to FIGS. 3A, 3B, 4, 5, 6 and 7. In general, the present disclosure proposes to use a model of voltage drop across the electrical connection elements (such as busbars 130-133) in order to obtain voltage correction values that can be used to correct e.g. the measured values $V_{(i-1)}$ - $V_i$ in order to improve the estimation of the corresponding battery cell terminal voltage $V_{Ci}$.

FIG. 3A schematically illustrates an exemplary geometry of an electrical connection element 300 in form of a cell-to-cell busbar. For illustrative purposes, the geometry is rather trivial and corresponds to a rectangular plate 310 provided with two holes 320 and 322 for connecting/attaching the plate 310 to respective battery cell terminals as described earlier herein with reference to e.g. FIG. 1. The plate 310 has a size $d_1$ (e.g. width) in an x-dimension, a size $d_2$ (e.g. length) in a y-dimension, and a size $d_3$ (e.g. height/thickness) in a z-dimension (not shown, but considered to be e.g. orthonormal to the x- and y-dimensions). Of course, the real geometry of the busbar 300 may be more complex than such, but the solution of the present disclosure allows to take also more complex geometries of the busbar into account as part of creating the envisaged model.

In particular, it is envisaged that there is a measurement point 340 defined on the surface of the plate 310, e.g. at a location defined by a point $p_m = (p_{mx}, p_{my})$ defined in relation to some assumed coordinate system center, such as the point $p_0 = (p_{0x}, p_{0y})$ shown in FIG. 3A, where e.g. $p_{0x} = p_{0y} = 0$.

When current flows between the holes (terminal connection points) 320 and 322, the current may not necessarily flow only in a straight path from e.g. hole 320 to 322. To the contrary, the flow of current and accompanying current density may be more complex than that and vary with position on the busbar, and depend e.g. on the exact geometry of the busbar 300, the material and electrical properties of the busbar 300, the dimensions $d_1$ to $d_3$ of the busbar 300, and similar. As envisaged herein, in some examples, the current flow and current density across/over the busbar 300 may also depend on e.g. an overall magnitude of current $I_i$ passing from hole 320 to 322 (or the other way around), and/or on a temperature $T_{Bi}$ of the busbar 300, and/or on one or more other parameters of the busbar 300 and/or battery 100 setup. Consequently, a current density at the point $p_m$ is not necessarily equal to a current density at some other point of/on the busbar 300, and it is thus also likely that the voltage drop between the point $p_m$ and e.g. the hole 320 or 322 will depend on the position of the point $p_m$ in a nonlinear fashion, and optionally also on factors such as the current $I_i$ and/or temperature $T_{Bi}$, and/or one or more additional factors.

As envisaged herein, a model of voltage drop across the busbar 300 may be formed by e.g. performing experiments (such as in laboratory) and/or by using one or more numerical methods (such as finite element methods/analysis, FEM/FEA, or derivatives thereof) to simulate the behavior of the busbar 300 to find how voltage drop between e.g. terminal connection points and measurement points vary for different terminal connection and measurement points setups.

In one example, it is envisaged that the position of the point 340 ($p_m$) is first fixed to a location corresponding to where the measurement point 14i is located on the corresponding i:th busbar 13i of the battery (arrangement) 100, if assuming that the busbar 300 corresponds to such an i:th busbar 13i. It is also envisaged that the geometry of the busbar 300 used for such experiments/simulations corresponds as much as possible to, or deviates within reasonable limits from, the geometry of the busbar 13i. Experiments/simulations can then be performed e.g. for different currents $I_i$, and/or temperatures $T_{Bi}$, and similar. For example, if using manual or automated experiments, controlled measurements of e.g. voltage drops between the point $p_m$ and e.g. one or both of the holes 320 and 322 may be performed for different currents $I_i$ and/or temperatures $T_{Bi}$, using a laboratory setup that allows to vary such one or more parameters in a controlled way. The resulting measurement values may be recorded and stored in e.g. a database, lookup table, or similar, such that each measurement value is associated with e.g. the current and/or temperature that was used when performing that particular measurement. Likewise, if using numerical simulations, such parameters may be varied as part of the simulation, and the resulting simulation results of voltage drop between the point $p_m$ and one or both of the holes 320 and 322 may be recorded in a similar fashion as if doing manual or automated experiments in a laboratory.

Other examples are of course also envisaged, including e.g. to perform experiments/simulations for a plurality of different geometries, e.g. by varying one or more of the dimensions $d_1$ to $d_3$ and also associating each resulting voltage drop value with the used dimensions $d_1$ to $d_3$, and/or e.g. by varying the position of $p_m$, thereby providing multiple sets of one or more voltage drops, each set corresponding to a different position of $p_m$, etc.

How e.g. voltage drop depends on dimensions $d_1$ to $d_3$, temperature $T_{Bi}$, current $I$, position $p_m$, as well as e.g. on the position of holes 330 and 332 may be further analyzed in order to find mathematical expressions expressing the voltage drop as a function of one or more of these parameters. If the voltage drop is e.g. found to depend linearly on one or more of these parameters, it may not be necessary to store as many different measurement/simulation results as otherwise, as interpolation and/or extrapolation can then be performed in order to find the voltage drop for a particular parameter value setup, even if such a particular parameter value setup was not among the various setups investigated during the experiment/simulation. Also, even if one or more parameters do not have a linear effect on the voltage drop, it may still be possible to quantify such relations using one or more mathematical expressions, e.g. as analytical functions of the one or more different parameters. In other examples, it is envisaged that interpolation and/or extrapolation may also be used even if the dependence of the parameter in question is not linear, as it is envisaged that the overall accuracy of battery cell terminal voltage-estimation may still be improved compared with using no voltage correction values at all.

In general, it is envisaged that a model of voltage drop across the electrical connection element (such as the busbar 300) at least provides a voltage drop between at least one point $p_m$ and at least one of the holes 320 and 322, preferably between at least one point $p_m$ and both of the holes 320 and 322, or provides other data from which such voltage drop(s) may be derived.

**FIG. 3B** schematically illustrates an exemplary model 301 of the busbar 300, wherein (based on e.g. impedances 330 and 332 between the point 340 ($p_m$) and each of the holes 320 and 322) the voltage drops $V_{Zi,1}$ and $V_{Zi,2}$ are provided for the $i$:th busbar. By having access to such experimental/simulated voltage drops, it is evident from the circuit 200 of FIG. 2 that instead of estimating the battery cell terminal voltage $V_{Ci}$ as $V_{Ci} \approx V_{(i-1)} - V_i$, the battery cell terminal voltage $V_{Ci}$ can (much) more accurately be estimated as

$$V_{Ci} \approx V_{(i-1)} - V_i - V_{Z(i-1),2} - V_{Zi,1}.$$

Experiments performed to validate the solution of the present disclosure has shown that the accuracy of estimating $V_{Ci}$ can be improved by at least a couple of percent, such as e.g. with 2%, which may provide a significant contribution to the overall accuracy of SoX value estimation and thereby positively influence e.g. battery management and similar.

In what follows, one or more examples of how the model of voltage drop across the electrical connection element can be obtained will now be described in more detail.

A geometry G of a particular electrical connection element (hereinafter exemplified by a busbar) may be defined using one or more parameters (such as dimensions $d_1$ to $d_3$ if using the example of FIGS. 3A and 3B), by a mesh grid (such as a collection of points and edges in 3D-space), a combination of both, or any by other suitable way of representing a three-dimensional object (or even a two-dimensional object, if e.g. a particular dimension of the object is sufficiently small to discard that dimension, and similar). In addition, the geometry G may include other parameters indicating e.g. from which material(s) the busbar is manufactured, what material properties such a material has, e.g. as relevant to its electrical properties, and similar. In other examples, such material and electrical parameters may be provided as a separate set of parameters.

A set of positions $p_{term} = \{p_+, p_-\}$ may be used to indicate the location of the points of the busbar at which the battery cell terminals are to be connected, where e.g. $p_+$ and $p_-$ are the position of the part of the busbar attaching to the positive and negative terminal of the battery cell, respectively. Likewise, a position $p_m$ may be used to indicate the position on the busbar of the measurement point at which the single spot voltage measurement is to be performed. There may of course in some examples e.g. be more than two battery cell terminal attachment points, in which case $p_{term}$ may include positions for each such attachment point.

After having defined such parameters, it is envisaged that numerical simulations may be performed in order to calculate what the voltage drop is between e.g. $p_m$ and each point of $p_{term}$. Such numerical simulations may for example be performed using finite element methods and analysis (FEM and FEA) or similar, e.g. as utilized in contemporary software packages such as those provided by Patran, ANSYS, Femap, Simscale, and others. In some examples, such simulations may be performed e.g. for different current magnitudes $I$, for different busbar temperatures $T_B$, or similar, and the results may be stored in e.g. a database/lookup table such that they (i.e. the model) may be used by a computer system as envisaged herein to obtain voltage correction values without having to redo the numerical simulations (such as by using FEM/FEA) each time a new voltage correction value is requested from the model.

For example, it may be envisaged that e.g. a voltage drop $V_{m,+}$ between $p_m$ and $p_+$ is provided by a hypothetical function f, such that e.g.

$$V_{m,+} = f(G, p_+, p_m, [P]),$$

where the full function $f$ may of course not necessarily be expressed using analytical expressions (i.e. fully known), and where $[P]$ is an optional set of one or more additional parameters, such as $I$ and/or $T_B$. However, by using numerical simulations, the value of $V_{m,+}$ for a set of exemplary argument values for $f$ may be obtained and stored as part of the model of voltage drop for the busbar. Such exemplary argument values may e.g. be values that are expected to be similar (e.g. within a same range) as those obtained during actual use of the battery.

In one example, it is envisaged to fix at least $G$, $p_+$ and $p_m$, in accordance with e.g. a known geometry $G$ of the busbar, as well as with known positions of $p_+$ and $p_m$ (as well as for known material properties of the busbar, such as the material used, its electrical properties in terms of e.g. conductivity, etc., and similar). It may then be performed numerical simulations e.g. for a base value of the current $I$ and/or temperature $T_B$, in which case the model includes at least a single value $V_{m,+}$ that can be used as the envisaged voltage correction value, e.g. as the value of any one of $V_{Zi,2}$ if using the nomenclature introduced in combination with FIG. 2, and if e.g. all of the cell-to-cell busbars in question are similar or equal, with similar or equal geometries, positions of the measurement points 14$i$, etc.

In other examples, there may be performed numerical simulations for different currents $I$ and/or temperatures $T_B$, thus resulting in a plurality of resulting voltage correction values $V_{m,+}$ for different $I$ and/or $T_B$. In other examples, further analysis may be applied to determine a mathematical relationship between $V_{m,+}$ and $I$ and/or $T_B$, e.g. to determine $V_{m,+} = f([P])|_{G,p+,pm}$, such as e.g. $V_{m,+} = f(I)|_{G,p+,pm}$, $V_{m,+} = f(T_B)|_{G,p+,pm}$, or e.g. $V_{m,+} = f(I, T_B)|_{G,p+,pm}$, where "$|_{G,p+,pm}$" means "for fixed values of $G, p_+$ and $p_m$. If such mathematical relationships are determined, this may help to provide a more accurate estimation of $V_{m,+}$ also for values of $I$ and/or $T_B$ that were not evaluated as part of the numerical simulations. In particular, such relationships may be non-linear and serve as a better way of, or even replace a need for, interpolating between nearby parameter values or even storing such nearby parameter values at all.

Similarly, such numerical simulations and/or further analysis may also be performed to find e.g. $V_{m,-}$, i.e. the voltage drop between the measurement point $p_m$ and the position of the negative battery cell attachment/-connection point $p_-$, i.e. to find

$$V_{m,-} = g(G, p_-, p_m, [P]),$$

in order to use such results (as stored in/provided as part of the model of voltage drop) to estimate/obtain e.g. the voltage correction $V_{Zi,1}$.

In summary of the above examples, it is thus envisaged herein to estimate a function (or functions) relating the various voltage drops $V_{Zi,1/2}$ to parameters such as $G, p_m, p_{term}$, and optionally also to e.g. $[P]$ (such as $I$ and/or $T_B$). In particular, it is envisaged that $G, p_m$ and $p_{term}$ may be fixed in accordance with the properties of the actual busbar, and that e.g. simulations may then be performed for a single value of $I$ and/or $T_B$ or for multiple values of $I$ and/or $T_B$. In the latter case, analytical expressions for how the voltage drop depends on $I$ and/or $T_B$ may be derived from such simulation results, and used to reduce the amount of data that needs to be stored as part of the model of voltage drop for the busbar. By fixing $G, p_m$ and $p_{term}$, the numerical simulations may be performed e.g. offline, and allow to find more reasonable analytical expressions as variations in e.g. $G, p_m$ and/or $p_{term}$ are not needed to be accounted for. However, it may also be envisaged that if it is possible to for example parametrize $G$ with only a few different parameters, such as e.g. sizes $d_1$ to $d_3$, and e.g. with one or few material property parameters, analytical expressions may also be derived for such a case, e.g. such that

$$V_{m,+/-} = f(\{G_{param}\}, [P])|_{p_m, p_{+/-}},$$

or similar, where $\{G_{param}\}$ is a set of parameters parametrizing the geometry $G$.

As used herein, fixing of G, $p_m$ and $p_{term}$ (e.g. $p_{+/-}$) is envisaged as being a reasonable assumption if e.g. all cell-to-cell busbars for which voltage corrections are to be determined are of a same type, e.g. produced by a same factory, in a same batch, or similar, and that e.g. the assembly of the battery is such that the positions $p_m$ and $p_{+/-}$ are equal for all cell-to-cell busbars (such as may be assumed if e.g. performed using one or more robotic workers, such as industrial robots, or similar, with sufficiently high accuracy and repeatability). In other examples, such restrictions may be released, and there may e.g. be provided separate models for different types of busbars (e.g. geometries), for different positions $p_m$ and/or $p_{term}$, and similar, if it is not expected that the busbars are sufficiently equal to use a same model for all of them. It may then be provided information connecting a particular busbar with a particular model of voltage drop across that busbar, etc.

As already mentioned herein, for the sake of completeness, it is noted that a similar model of voltage drop across a busbar (or other electrical connector element) may also, at least under some suitable conditions, be obtained using other means than numerical simulations, such as by manual (or automated) experiments in a controlled lab environment.

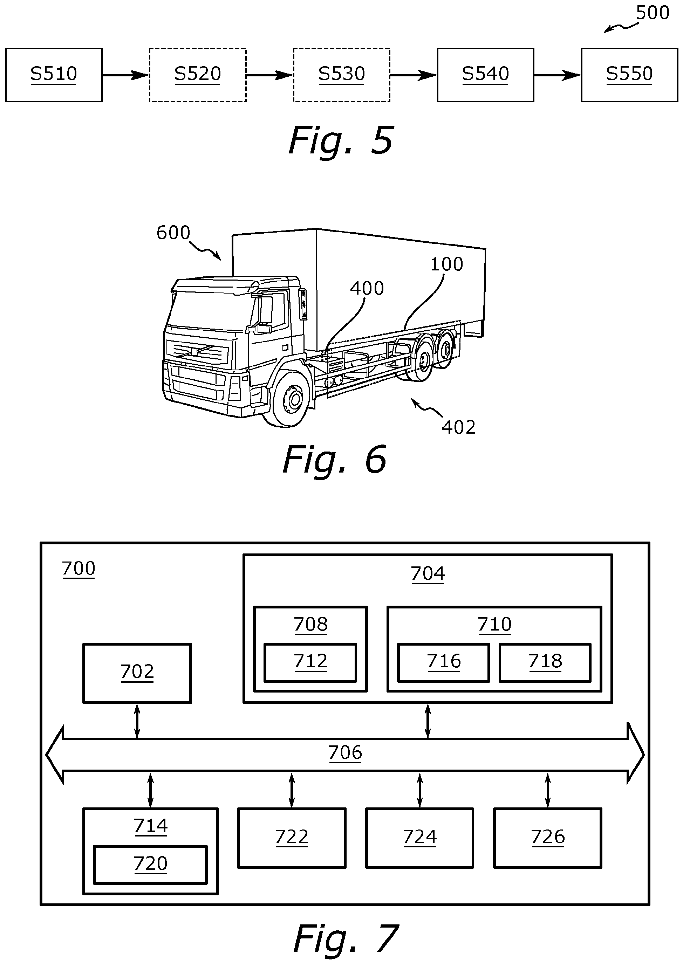

**FIG. 4** schematically illustrates an overview of a computer system 400 according to examples of the present disclosure, and **FIG. 5** schematically illustrates a flowchart of an exemplary (computer-implemented) method 500 that may be performed e.g. by processing circuitry 410 of the computer system 400.

The processing circuitry 410 is configured to, in cooperation with e.g. other parts of the computer system 400, receive voltage measurements from the measurement points (as part of e.g. an operation S510 of the method 500), such as 140 to 143 (e.g. $V_{(i-1)}$ and $V_i$ separately, or e.g. the difference $V_{(i-1)} - V_i$ directly), as part of a message 420 (wherein as used herein, a "message" is e.g. an electronic signal that the processing circuitry 410 may read/understand, or e.g. an optical signal, radio signal, or other equivalents). Phrased differently, the processing circuitry 410 is configured to (as part of e.g. the operation S510) obtain a first voltage drop value (such as e.g. $V_2 - V_3$) indicative of a voltage drop across at least i) a battery cell (such as e.g. 110-3) and ii) at least a part of an electrical connection element (such as e.g. the part $Z_{3,1}$ of the busbar 133) that connects the battery cell to another object (such as another battery cell or similar) of a battery (such as the battery 100).

The processing circuitry 410 is further configured to (as part of e.g. an operation S540 of the method 500) obtain a voltage correction value (such as e.g. $V_{Z3,1}$) from a model 430 of voltage drop across the electrical connection element (e.g. the estimation of *f* or e.g. *g,* as stored in a database/lookup table 432 or similar to which the processing circuitry 410 has access).

The processing circuitry 410 is further configured to (as part of e.g. an operation S550 of the method 500) estimate a terminal voltage (e.g. $V_{C3}$) of the battery cell based on the first voltage drop value corrected by the voltage correction value (e.g. by subtracting at least $V_{Z3,1}$ from the value $V_2 - V_3$).

Of course, the envisaged computer system 400 and method 500 may also include to e.g. receive voltage correction values for all electrical connection elements that contribute to the overall first voltage drop (such as e.g. also for the busbar 132, including e.g. $V_{Z,2}$) and to use also such voltage correction values more accurately estimating the terminal voltage of the battery cell (such as by estimating e.g. $V_{C3}$ by subtracting both $V_{Z,2}$ and $V_{3,1}$ from $V_2 - V_3$). Likewise, a same processes may of course also be performed for all battery cell terminal voltages of interest (such as e.g. also for the estimation of $V_{C1}$ and $V_{C2}$). It should however be noted that the envisaged method 500 and computer system 400 are not only applicable to battery cells and their interconnecting busbars, but also for other electrical connection elements that may connect a battery cell to one or more other objects of the battery, and for which accurate estimation of battery cell terminal voltage is desirable based on a measurement of a voltage drop across the battery cell and at least part of the electrical connection element. For example, such another type of electrical connector element may be a busbar not used as a cell-to-cell busbar, such as e.g. a busbar used to connect a battery cell terminal to a control circuit of the battery, to a battery terminal of the battery, or similar.

Optionally, the processing circuitry 410 may in some examples be further configured to (as part of e.g. an optional operation S520 of the method 500) obtain a current value $I_i$ (as part of e.g. a message 422) indicative of a current through the electrical connection element, such as the current *I* through the battery cells 110-1 to 110-3 shown in FIG. 1. The processing circuitry 410 may use this additional information $I_i$ (or just *I*) as input to the model 430, if assuming that the model 430 includes the results of numerical simulations performed for different values of *I*, and/or at least some analytical expression for the dependence of the voltage drop on *I*. The value of *I* may for example be obtained by the processing circuitry 410 being configured to communicate with one or more suitable current sensors configured to sense such a current *I*.

Optionally, the processing circuitry 410 may in some examples be further configured to (as part of e.g. an optional operation S530 of the method 500) obtain a temperature value $T_{Bi}$ indicative of a temperature of the electrical connection element, as part of e.g. a message 424. The processing circuitry 410 may use this additional information $T_{Bi}$ as input to the model 430, if assuming that the model 430 includes the results of numerical simulations performed for different values of $T_{Bi}$, and/or at least some analytical expression for the dependence of the voltage drop on $T_{Bi}$. The temperature value $T_{Bi}$ may for example be obtained directly from e.g. the temperature sensor 152, and/or indirectly from readings of temperature sensors such as 150 (e.g. from battery cell temperature $T_{Ci}$) and/or 154 (e.g. from battery ambient temperature $T_A$), and similar, and it is assumed that the processing circuitry 510 may in some examples be configured to communicate (e.g. by receiving the message 424) with one or more of such temperature sensors 150, 152 and/or 154.

Optionally, the processing circuitry 410 may in some example be further configured to e.g. calculate one or more SoX values for the battery cell (or for the whole battery) based on the estimated terminal voltage, such as e.g. SoC, SoH, SoE, SoP, and similar. In some examples, the processing circuitry 410 may be further configured to control a charging and/or discharging of the battery 100 based on e.g. the determined battery cell terminal voltage and/or the one or more calculated SoX values, e.g. by one or more control messages 440 sent to the battery 100 (or, more specifically, to circuitry responsible for e.g. limiting a (dis)charging current, (dis)charging rate, temperature, and similar of the battery cell and/or battery 100.

FIG. 4 also serves to illustrate an exemplary battery arrangement 402 according to examples of the present disclosure. The battery arrangement 402 includes the battery 100 and the computer system 400. In some examples, the storage medium 432 (e.g. database, lookup table, or similar) used to store/represent the model 430 may also form part of the battery arrangement 402. In some examples, the storage medium 432 may even form part of the computer system 400, and be implemented by storing in one or more memories of the computer system 400 to which the processing circuitry 410 has direct or indirect access.

**FIG. 6** schematically illustrates an exemplary vehicle 600, here illustrated as a heavy vehicle in form of a truck. The vehicle 600 includes a battery 100 as described herein, a computer system 400 as also envisaged herein (i.e. a battery arrangement 402 as envisaged herein). Other types of vehicles than a truck are of course also envisaged, such as electric cars, marine vessels, or any type of vehicle in which the battery 100 may form part, and e.g. be used for providing power to one or more electrical machines responsible for propelling the vehicle, or at least partially responsible for propelling the vehicle in case the vehicle is not fully electric but e.g. a hybrid electric vehicle, or similar.

More generally, a "battery arrangement" as described herein may also be referred to, or form part of, an energy storage system, and may also be used as part of other things than vehicles, such as for example off-grid battery solutions, electrical grid reserve systems (such as battery banks and similar), or any other type of system that includes a battery with a plurality of battery cells, and wherein accurate estimation of battery cell terminal voltage (in order to e.g. calculate one or more SoX values of the battery cell(s) and/or battery) is desirable.

Generally herein, the envisaged solution may be useful both when estimating open-circuit battery terminal voltage (OCV, i.e. in a relaxed state without any loading of the battery) and closed-circuity battery terminal voltage (CCV, i.e. the terminal voltage under loading of the battery, e.g. during use/driving of an electric vehicle or similar). Various models for e.g. estimating OCV based on CCV are commonly known, and by providing the means to correct for the fact that the busbars have finite impedances allows also such estimations to be more accurate.

**FIG. 7** schematically illustrates a diagram of a computer system 700 for implementing examples disclosed herein, such as the computer system 400 described with reference to FIG. 4. The computer system 700 is adapted to execute instructions from a computer-readable medium to perform these and/or any of the functions or processing described herein. The computer system 700 may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system 700 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 700 may comprise at least one computing device or electronic device capable of including firmware, hardware, and/or executing software instructions to implement the functionality described herein. The computer system 700 may include processing circuitry 702 (e.g., processing circuitry including one or more processor devices or control units), a memory 704, and a system bus 706. The computer system 700 may include at least one computing device having the processing circuitry 702. The system bus 706 provides an interface for system components including, but not limited to, the memory 704 and the processing circuitry 702. The processing circuitry 702 may include any number of hardware components for conducting data or signal processing or for executing computer code stored in memory 704. The processing circuitry 702 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 702 may further include computer executable code that controls operation of the programmable device.

The system bus 706 may be any of several types of bus structures that may further interconnect to a memory bus (with or without a memory controller), a peripheral bus, and/or a local bus using any of a variety of bus architectures. The memory 704 may be one or more devices for storing data and/or computer code for completing or facilitating methods described herein. The memory 704 may include database components, object code components, script components, or other types of information structure for supporting the various activities herein. Any distributed or local memory device may be utilized with the systems and methods of this description. The memory 704 may be communicably connected to the processing circuitry 702 (e.g., via a circuit or any other wired, wireless, or network connection) and may include computer code for executing one or more processes described herein. The memory 704 may include non-volatile memory 708 (e.g., read-only memory (ROM), erasable programmable read-only memory (EPROM), electrically erasable programmable read-only memory (EEPROM), etc.), and volatile memory 710 (e.g., random-access memory (RAM)), or any other medium which can be used to carry or store desired program code in the form of machine-executable instructions or data structures and which can be accessed by a computer or other machine with processing circuitry 702. A basic input/output system (BIOS) 712 may be stored in the non-volatile memory 708 and can include the basic routines that help to transfer information between elements within the computer system 700.

The computer system 700 may further include or be coupled to a non-transitory computer-readable storage medium such as the storage device 714, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 714 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device 714 and/or in the volatile memory 710, which may include an operating system 716 and/or one or more program modules 718. All or a portion of the examples disclosed herein may be implemented as a computer program 720 stored on a transitory or non-transitory computer-usable or computer-readable storage medium (e.g., single medium or multiple media), such as the storage device 714, which includes complex programming instructions (e.g., complex computer-readable program code) to cause the processing circuitry 702 to carry out actions described herein. Thus, the computer-readable program code of the computer program 720 can comprise software instructions for implementing the functionality of the examples described herein when executed by the processing circuitry 702. In some examples, the storage device 714 may be a computer program product (e.g., readable storage medium) storing the computer program 720 thereon, where at least a portion of a computer program 720 may be loadable (e.g., into a processor) for implementing the functionality of the examples described herein when executed by the processing circuitry 702. The processing circuitry 702 may serve as a controller or control system for the computer system 700 that is to implement the functionality described herein.

The computer system 700 may include an input device interface 722 configured to receive input and selections to be communicated to the computer system 700 when executing instructions, such as from a keyboard, mouse, touch-sensitive surface, etc. Such input devices may be connected to the processing circuitry 702 through the input device interface 722 coupled to the system bus 706 but can be connected through other interfaces, such as a parallel port, an Institute of Electrical and Electronic Engineers (IEEE) 1394 serial port, a Universal Serial Bus (USB) port, an IR interface, and the like. The computer system 700 may include an output device interface 724 configured to forward output, such as to a display, a video display unit (e.g., a liquid crystal display (LCD) or a cathode ray tube (CRT)). The computer system 700 may include a communications interface 726 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

In summary of all of the above, the present disclosure provides an improved solution of estimating a terminal voltage of a battery cell of a battery, especially where a voltage drop across the battery cell is not measured directly across the battery cell terminals but instead by so-called single spot measurements between single measurement points on each electrical connection element (e.g. busbar) interconnecting multiple battery cells. By providing and using one or more pre-determined/-calculated models of voltage drop across the electrical connection elements, the contribution of these elements to the measured voltage drop can be compensated for, and thereby allow to obtain a more accurate estimate of the true battery cell terminal voltage. This may be important in that things like SoX values are often calculated based on such estimated battery cell voltages, and as more accurate battery cell terminal voltage estimates will lead to more accurate SoX value estimates and in the end to more accurate and satisfactory overall control of the battery, such as control of discharging, charging, battery-internal cell balancing, and similar.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

The following is an exemplifying list of examples envisaged herein:

Example 1: A computer system (400, 700) for estimating a terminal voltage of a battery cell (110-3) of a battery (100), wherein a terminal (114-3) of the battery cell is electrically connected to another object of the battery via an electrical connection element (133), wherein
the computer system includes processing circuitry (410, 702) configured to: obtain a first voltage drop value indicative of a voltage drop across at least i) the battery cell and ii) at least a part of the electrical connection element; obtain a voltage correction value from a model (430; f, g) of voltage drop across the electrical connection element, and estimate a terminal voltage of the battery cell based on the first voltage drop value corrected by the voltage correction value.

Example 2: The computer system of example 1, wherein the model of voltage drop depends on a current through the electrical connection element, and wherein the processing circuitry is further configured to: obtain a current value indicative of a current (I) through the electrical connection element, and obtain the voltage correction value from the model based on the current value.

Example 3: The computer system of example 1 or 2, wherein the model of voltage drop depends on a temperature of the electrical connection element, and wherein the processing circuitry is further configured to: obtain a temperature value indicative of a temperature of the electrical connection element, and obtain the voltage correction value from the model based on the temperature value.

Example 4: The computer system of any one of examples 1 to 3, wherein the model of voltage drop is specific for a voltage drop between a point (143) of the electrical connection element used for obtaining the first voltage drop value and a point of the electrical connection element used for attaching the electrical connection element to the terminal of the battery cell.

Example 5: The computer system of any one of the preceding examples, wherein the processing circuitry is further configured to calculate a state-of-X (SoX) value for the battery cell based on the estimated terminal voltage.

Example 6: The computer system of example 5, wherein the processing circuitry is further configured to control charging and/or discharging of the battery cell or battery based on the determined SoX value for the battery cell.

Example 7: A battery arrangement (402), including: a battery (100) including a plurality of battery cells (110-1, 110-2, 110-3) electrically connected in series via a plurality of electrical connection elements (130-133), and the computer system (400, 700) of any one of examples 1 to 6 for estimating a terminal voltage of at least one (110-3) of said battery cells.

Example 8: The battery arrangement of example 7, wherein the electrical connection elements are cell-to-cell busbars.

Example 9: A vehicle (600) including the battery arrangement (402) of example 7 or 8.

Example 10: A computer-implemented method (500) of estimating a terminal voltage of a battery cell (110-3) of a battery (100), wherein a terminal (114-3) of the battery cell is electrically connected to another object of the battery via an electrical connection element (133), wherein the method is performed by processing circuitry (410, 702) of a computer system (400, 700) and includes: obtaining (S510) a first voltage drop value indicative of a voltage drop across at least i) the battery cell and ii) at least a part of the electrical connection element; obtaining (S540) a voltage correction value from a model (430; f, g) of voltage drop across the electrical connection element, and estimating (S550) a terminal voltage of the battery cell based on the first voltage drop value corrected by the voltage correction value. Example 11: The method of example 10, wherein the model of voltage drop depends on a current through the electrical connection element, and wherein the method further includes: obtaining (S520) a current value indicative of a current (I) through the electrical connection element, and obtaining the voltage correction value from the model based on the current value.

Example 12: The method of example 10 or 11, wherein the model of voltage drop depends on a temperature of the electrical connection element, and wherein the method further includes: obtaining (S530) a temperature value indicative of a temperature of the electrical connection element, and obtaining the voltage correction value from the model based on the temperature value.

Example 13: The method of any one of examples 10 to 12, wherein the model of voltage drop is specific for a voltage drop between a point of the electrical connection element used for obtaining the first voltage drop value and a point of the electrical connection element used for attaching the electrical connection element to the terminal of the battery cell.

Example 14: The method of any one of examples 10 to 13, wherein the method further includes providing the model of voltage drop based on numerical simulations of voltage drop for the electrical connection element, such as based on finite element methods/analysis, FEM/FEA.

Example 15: A computer program product (714) including program code (720) for performing, when executed a processing circuitry (410, 702) of a computer system (400, 700), the method (500) of any one of examples 10 to 14.

Example 16: A computer-readable storage medium including instructions, which when executed by a/the processing circuitry, cause the processing circuitry to perform the method of any one of examples 10 to 14. The storage medium may be non-transitory.

**Claims**

1. A computer system (400, 700) for estimating a terminal voltage ($V_{C3}$) of a battery cell (110-3) of a battery (100), wherein a terminal (114-3) of the battery cell is electrically connected to another object of the battery via an electrical connection element (133), wherein the computer system comprises processing circuitry (410, 702) configured to:

   - obtain a first voltage drop value ($V_2 - V_3$) indicative of a voltage drop across at least i) the battery cell and ii) at least a part ($Z_{3,1}$) of the electrical connection element;
   - obtain a voltage correction value ($V_{Z3,1}$) from a model (430; f, $g$) of voltage drop across the electrical connection element, and
   - estimate a terminal voltage ($V_{C3}$) of the battery cell based on the first voltage drop value corrected by the voltage correction value ($V_{C3} \approx V_2 - V_3 - V_{Z3,1} - \cdots$).

2. The computer system of claim 1, wherein the model of voltage drop depends on a current through the electrical connection element, and wherein the processing circuitry is further configured to:

   - obtain a current value indicative of a current ($I$) through the electrical connection element, and
   - obtain the voltage correction value from the model based on the current value.

3. The computer system of claim 1 or 2, wherein the model of voltage drop depends on a temperature of the electrical connection element, and wherein the processing circuitry is further configured to:

   - obtain a temperature value indicative of a temperature ($T_{Bi}$) of the electrical connection element, and
   - obtain the voltage correction value from the model based on the temperature value.

4. The computer system of any one of claims 1 to 3, wherein the model of voltage drop is specific for a voltage drop between a point (143, $p_m$) of the electrical connection element used for obtaining the first voltage drop value and a point ($p\_$) of the electrical connection element used for attaching the electrical connection element to the terminal of the battery cell.

5. The computer system of any one of the preceding claims, wherein the processing circuitry is further configured to determine a state-of-X (SoX) value for the battery cell based on the estimated terminal voltage.

6. The computer system of claim 5, wherein the processing circuitry is further configured to control charging and/or discharging of the battery cell or battery based on the determined SoX value for the battery cell.

7. A battery arrangement (402), comprising:

   - a battery (100) comprising a plurality of battery cells (110-1, 110-2, 110-3) electrically connected in series via a plurality of electrical connection elements (130-133), and
   - the computer system (400, 700) of any one of claims 1 to 6 for estimating a terminal voltage ($V_{C3}$) of at least one (110-3) of said battery cells.

8. The battery arrangement of claim 7, wherein the electrical connection elements are cell-to-cell busbars.

9. A vehicle (600) comprising the battery arrangement (402) of claim 7 or 8.

10. A computer-implemented method (500) of estimating a terminal voltage ($V_{C3}$) of a battery cell (110-3) of a battery (100), wherein a terminal (114-3) of the battery cell is electrically connected to another object of the battery via an electrical connection element (133), wherein the method is performed by processing circuitry (410, 702) of a computer system (400, 700) and comprises:

   - obtaining (S510) a first voltage drop value ($V_2 - V_3$) indicative of a voltage drop across at least i) the battery cell and ii) at least a part ($Z_{3,1}$) of the electrical connection element;

- obtaining (S540) a voltage correction value ($V_{Z3,1}$) from a model (430; f, g) of voltage drop across the electrical connection element, and
- estimating (S550) a terminal voltage ($V_{C3}$) of the battery cell based on the first voltage drop value corrected by the voltage correction value ($V_{C3} \approx V_2 - V_3 - V_{Z3,1} - \cdots$).

11. The method of claim 10, wherein the model of voltage drop depends on a current through the electrical connection element, and wherein the method further comprises:

- obtaining (S520) a current value indicative of a current ($I$) through the electrical connection element, and
- obtaining the voltage correction value from the model based on the current value.

12. The method of claim 10 or 11, wherein the model of voltage drop depends on a temperature of the electrical connection element, and wherein the method further comprises:

- obtaining (S530) a temperature value indicative of a temperature ($T_{Bi}$) of the electrical connection element, and
- obtaining the voltage correction value from the model based on the temperature value.

13. The method of any one of claims 10 to 12, wherein the model of voltage drop is specific for a voltage drop between a point (143, $p_m$) of the electrical connection element used for obtaining the first voltage drop value and a point (p_) of the electrical connection element used for attaching the electrical connection element to the terminal of the battery cell.

14. The method of any one of claims 10 to 13, wherein the method further comprises providing the model of voltage drop based on numerical simulations of voltage drop for the electrical connection element, such as based on finite element methods/analysis, FEM/-FEA.

15. A computer program product (714) comprising program code (720) for performing, when executed by a processing circuitry (410, 702) of a computer system (400, 700), the method (500) of any one of claims 10 to 14.

**Amended claims in accordance with Rule 137(2) EPC.**

1. A computer system (400, 700) for estimating a terminal voltage ($V_{C3}$) of a battery cell (110-3) of a battery (100), wherein a terminal (114-3) of the battery cell is electrically connected to another object of the battery via an electrical connection element (133), wherein the computer system comprises processing circuitry (410, 702) configured to:

- obtain a first voltage drop value ($V_2 - V_3$) indicative of a voltage drop across at least i) the battery cell and ii) at least a part ($Z_{3,1}$) of the electrical connection element;
- obtain a voltage correction value ($V_{Z3,1}$) from a model (430; f, g) of voltage drop across the electrical connection element, and
- estimate a terminal voltage ($V_{C3}$) of the battery cell based on the first voltage drop value corrected by the voltage correction value ($V_{C3} \approx V_2 - V_3 - V_{Z3,1} - \cdots$),

**characterized by** the model of voltage drop being provided based on numerical simulations of voltage drop for the electrical connection element.

2. The computer system of claim 1, wherein the model of voltage drop depends on a current through the electrical connection element, and wherein the processing circuitry is further configured to:

- obtain a current value indicative of a current (I) through the electrical connection element, and
- obtain the voltage correction value from the model based on the current value.

3. The computer system of claim 1 or 2, wherein the model of voltage drop depends on a temperature of the electrical connection element, and wherein the processing circuitry is further configured to:

- obtain a temperature value indicative of a temperature ($T_{Bi}$) of the electrical connection element, and
- obtain the voltage correction value from the model based on the temperature value.

4. The computer system of any one of claims 1 to 3, wherein the model of voltage drop is specific for a voltage drop between a point (143, $p_m$) of the electrical connection element used for obtaining the first voltage drop value and a point (p_) of the electrical connection element used for attaching the electrical connection element to the terminal of the battery cell.

5. The computer system of any one of the preceding claims, wherein the processing circuitry is further configured to determine a state-of-X (SoX) value for the battery cell based on the estimated terminal voltage.

6. The computer system of claim 5, wherein the processing circuitry is further configured to control charging and/or discharging of the battery cell or battery based on the determined SoX value for the battery cell.

7. A battery arrangement (402), comprising:

- a battery (100) comprising a plurality of battery cells (110-1, 110-2, 110-3) electrically connected in series via a plurality of electrical connection elements (130-133), and
- the computer system (400, 700) of any one of claims 1 to 6 for estimating a terminal voltage ($V_{C3}$) of at least one (110-3) of said battery cells.

8. The battery arrangement of claim 7, wherein the electrical connection elements are cell-to-cell busbars.

9. A vehicle (600) comprising the battery arrangement (402) of claim 7 or 8.

10. A computer-implemented method (500) of estimating a terminal voltage ($V_{C3}$) of a battery cell (110-3) of a battery (100), wherein a terminal (114-3) of the battery cell is electrically connected to another object of the battery via an electrical connection element (133), wherein the method is performed by processing circuitry (410, 702) of a computer system (400, 700) and comprises:

- obtaining (S510) a first voltage drop value ($V_2$ - $V_3$) indicative of a voltage drop across at least i) the battery cell and ii) at least a part ($Z_{3,1}$) of the electrical connection element;
- obtaining (S540) a voltage correction value ($V_{Z3,1}$) from a model (430; $f$, $g$) of voltage drop across the electrical connection element, and
- estimating (S550) a terminal voltage ($V_{C3}$) of the battery cell based on the first voltage drop value corrected by the voltage correction value ($V_{C3} \approx V_2 - V_3 - V_{Z3,1} - \cdots$),

**characterized by** providing the model of voltage drop based on numerical simulations of voltage drop for the electrical connection element.

11. The method of claim 10, wherein the model of voltage drop depends on a current through the electrical connection element, and wherein the method further comprises:

- obtaining (S520) a current value indicative of a current ($I$) through the electrical connection element, and
- obtaining the voltage correction value from the model based on the current value.

12. The method of claim 10 or 11, wherein the model of voltage drop depends on a temperature of the electrical connection element, and wherein the method further comprises:

- obtaining (S530) a temperature value indicative of a temperature ($T_{Bi}$) of the electrical connection element, and
- obtaining the voltage correction value from the model based on the temperature value.

13. The method of any one of claims 10 to 12, wherein the model of voltage drop is specific for a voltage drop between a point (143, $p_m$) of the electrical connection element used for obtaining the first voltage drop value and a point ($p\_$) of the electrical connection element used for attaching the electrical connection element to the terminal of the battery cell.

14. A computer program product (714) comprising program code (720) for performing, when executed by a processing circuitry (410, 702) of a computer system (400, 700), the method (500) of any one of claims 10 to 13.

*Fig. 1*

*Fig. 2*

*Fig. 3A*

*Fig. 3B*

*Fig. 4*

**Fig. 5**

**Fig. 6**

**Fig. 7**

**EUROPEAN SEARCH REPORT**

Application Number

EP 23 21 9645

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | FR 3 131 457 A1 (RENAULT SAS [FR]; NISSAN MOTOR [JP]) 30 June 2023 (2023-06-30)<br>* figures 1-3 *<br>* paragraph [0001] *<br>* paragraph [0024] - paragraph [0090] *<br>- - - - - | 1-3,<br>5-12,15<br>4,13,14 | INV.<br>G01R31/367<br>G01R31/382<br>G01R31/396 |
| X<br><br>A | EP 3 327 454 A1 (SAMSUNG SDI CO LTD [KR]) 30 May 2018 (2018-05-30)<br>* figures 2-3 *<br>* paragraph [0007] - paragraph [0008] *<br>* paragraph [0016] *<br>* paragraph [0021] *<br>* paragraph [0052] - paragraph [0067] *<br>- - - - - | 1,5-8,<br>10,15<br>2-4,<br>11-14 | |
| X<br><br>A | EP 4 250 430 A1 (CONTEMPORARY AMPEREX TECHNOLOGY CO LTD [CN]) 27 September 2023 (2023-09-27)<br>* figures 1-3 *<br>* paragraph [0003] - paragraph [0004] *<br>* paragraph [0031] - paragraph [0038] *<br>* paragraph [0040] - paragraph [0047] *<br>* paragraph [0055] *<br>* paragraph [0058] - paragraph [0060] *<br>- - - - - | 1,2,<br>5-11,15<br>3,4,<br>12-14 | TECHNICAL FIELDS SEARCHED (IPC)<br><br>G01R<br>H01M |
| X<br><br>A | US 2014/017532 A1 (NISHIHARA YOSHITOMO [JP] ET AL) 16 January 2014 (2014-01-16)<br><br>* figures 1,2,4-6 *<br>* paragraph [0008] - paragraph [0010] *<br>* paragraph [0012] *<br>* paragraph [0014] *<br>* paragraph [0064] *<br>* paragraph [0070] - paragraph [0073] *<br>* paragraph [0076] - paragraph [0079] *<br>- - - - - | 1,2,<br>4-11,13,<br>15<br>3,12,14 | |

The present search report has been drawn up for all claims

| Place of search | Date of completion of the search | Examiner |
|---|---|---|
| Munich | 17 June 2024 | Nguyen, Minh |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 21 9645

This annex lists the patent family members relating to the patent documents cited in the above-mentioned European search report.
The members are as contained in the European Patent Office EDP file on
The European Patent Office is in no way liable for these particulars which are merely given for the purpose of information.

17-06-2024

| Patent document cited in search report | | Publication date | Patent family member(s) | | Publication date |
|---|---|---|---|---|---|
| FR 3131457 | A1 | 30-06-2023 | FR | 3131457 A1 | 30-06-2023 |
| | | | WO | 2023117556 A1 | 29-06-2023 |
| EP 3327454 | A1 | 30-05-2018 | EP | 3327454 A1 | 30-05-2018 |
| | | | HU | E052482 T2 | 28-04-2021 |
| | | | PL | 3327454 T3 | 06-04-2021 |
| EP 4250430 | A1 | 27-09-2023 | CN | 116391286 A | 04-07-2023 |
| | | | EP | 4250430 A1 | 27-09-2023 |
| | | | JP | 2024501255 A | 11-01-2024 |
| | | | KR | 20230109724 A | 20-07-2023 |
| | | | US | 2024061052 A1 | 22-02-2024 |
| | | | WO | 2023060380 A1 | 20-04-2023 |
| US 2014017532 | A1 | 16-01-2014 | JP | 5976634 B2 | 23-08-2016 |
| | | | JP | WO2012133592 A1 | 28-07-2014 |
| | | | US | 2014017532 A1 | 16-01-2014 |
| | | | WO | 2012133592 A1 | 04-10-2012 |

EPO FORM P0459

For more details about this annex : see Official Journal of the European Patent Office, No. 12/82